(19) Europäisches Patentamt

European Patent Office

Office européen des brevets

(11) Publication number: **0 138 406 B1**

# (12) EUROPEAN PATENT SPECIFICATION

(45) Date of publication of patent specification: **13.11.91**  (51) Int. Cl.⁵: **G11C  19/28**

(21) Application number: **84306388.4**

(22) Date of filing: **19.09.84**

(54) Shift register.

(30) Priority: **20.09.83 JP 172096/83**

(43) Date of publication of application:
**24.04.85 Bulletin  85/17**

(45) Publication of the grant of the patent:
**13.11.91 Bulletin  91/46**

(84) Designated Contracting States:
**DE FR GB**

(56) References cited:
**GB-A- 2 022 953**

**PATENT ABSTRACTS OF JAPAN, vol. 2, no.
55, 21st April 1978, page 1245 E 78; & JP-A-53
18 928 (MATSUSHITA DENKI SANGYO K.K.)
21-02-1978**

(73) Proprietor: **FUJITSU LIMITED
1015, Kamikodanaka Nakahara-ku
Kawasaki-shi Kanagawa 211(JP)**

(72) Inventor: **Takemae, Yoshihiro
303, 8-13-24, Akasaka Minato-ku
Tokyo 107(JP)**

(74) Representative: **Sunderland, James Harry et al
HASELTINE LAKE & CO Hazlitt House 28
Southampton Buildings Chancery Lane
London WC2A 1AT(GB)**

Note: Within nine months from the publication of the mention of the grant of the European patent, any person
may give notice to the European Patent Office of opposition to the European patent granted. Notice of opposition
shall be filed in a written reasoned statement. It shall not be deemed to have been filed until the opposition fee
has been paid (Art. 99(1) European patent convention).

## Description

The present invention relates to a shift register, and more particularly to a MIS dynamic shift register which can be composed by using a small number of circuit elements.

In a MIS dynamic memory device, for example, a so called auto-refresh operation for refreshing data stored in each memory cell is effected by memorizing the number (address) of a word line to be refreshed in the memory device, and by incrementing the number of the word line and refreshing the memory cells connected to each word line. In Japanese Patent Application No. 58-115887 filed on June 29, 1983 by the present applicant, there is disclosed a memory device which comprises a shift register disposed parallel to a row decoder and in which a selecting signal for a word line to be refreshed is generated using an output signal of the shift register, thereby sequentially selecting a word line to be refreshed. The shift register used in such a memory device is characterized in that, among all the bits thereof, the output of only one bit is "1" and the outputs of other bits are all "0". By using the output of the one bit which is "1", only one target word line is selected. It is also necessary that the width of one circuit stage on a semiconductor substrate of such a shift register be not larger than the pitch length of the word lines. Generally, since the pitch length of the word lines is very narrow, it is necessary that the structure of each circuit stage of the shift register be very simple and the number of circuit components used therein be small.

In a conventional shift register which can memorize and transmit data having any pattern, each circuit stage has a very complex circuit structure and a large number of circuit components. Therefore, the circuit width of each circuit stage on a semiconductor device is relatively large, and it is impossible to use such a shift register in the above-mentioned memory device.

In view of the problems of the aforementioned conventional shift register, the present invention adopts an idea of constituting each circuit stage in a MIS dynamic-type shift register by using three MIS transistors as base components.

GB-A-2 022 953 discloses a shift register having features corresponding to those of the preamble of accompanying claim 1.

According to the present invention, there is provided a shift register having a plurality of circuit stages connected in cascade and receiving first and second clock signals different in phase from each other for driving the shift register, each of said circuit stages comprising:

transfer means operatively connected to receive an input signal and said first clock signal including a first transistor having a source or drain for receiving said input signal;

a second transistor having a gate operatively connected via said first transistor to receive said input signal, a source and a drain, one of said source and drain receiving said second clock signal, said second transistor providing an output signal at the other of said source and drain in response to said input signal and said second clock signal; and

a reset means for resetting said output signal; characterised in that when said first clock signal is applied to said transfer means, said transfer means allows the transfer of said input signal and wherein said first clock signal or said transfer means is arranged such that when said first clock signal is not activated, the gate voltage of said first transistor is held between Vth and 2Vth; and in that said reset means operates in response to said output signal of a succeeding circuit stage of the shift register, the output signal of the circuit stage providing the input signal applied to the first transistor of the succeeding circuit stage of the shift register. Above, Vth denotes the threshold voltage of the first transistor.

An embodiment of the present invention can simplify the circuit structure of each circuit stage and decrease the number of circuit components used in each circuit stage, thereby decreasing the width of the space occupied by each circuit stage on a semiconductor substrate.

Reference is made, by way of example, to the accompanying drawings in which:

Figure 1 is a block circuit diagram illustrating a memory device which uses a shift register according to the present invention;

Figure 2 is an electric circuit diagram illustrating a shift register as an embodiment of the present invention;

Figure 3 is a waveform diagram illustrating the operation of the shift register of Fig. 2; and

Figures 4 and 5 are electric circuit diagrams each illustrating another embodiment of the present invention and each being a modification of the shift register of Fig. 1.

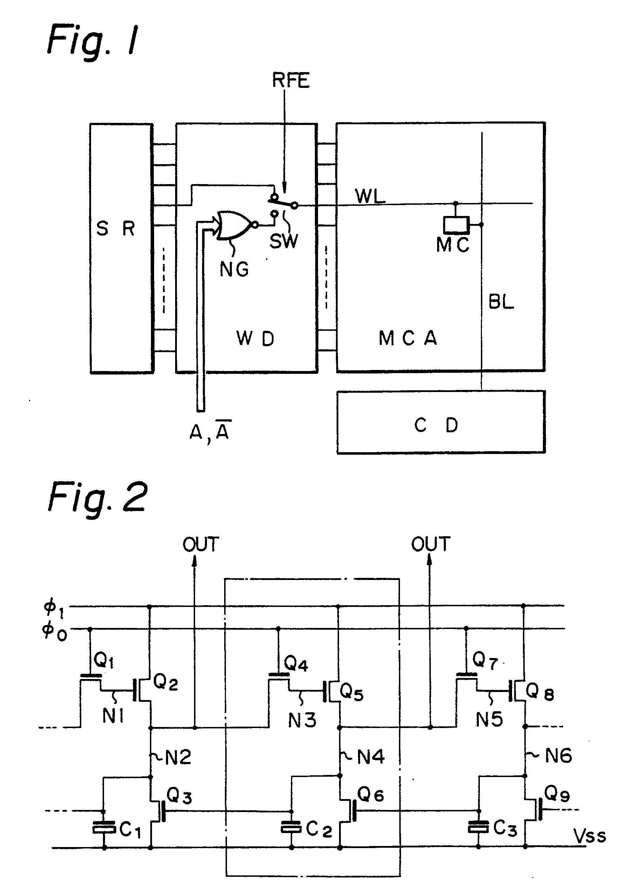

Figure 1 illustrates a dynamic memory device wherein a shift register, possibly a ring counter type shift register, is used to sequentially designate a word line connected to memory cells for the purpose of a refresh operation. The memory device of Fig. 1 comprises a memory cell array MCA having a plurality of memory cells MC each being connected to a bit line BL and a word line WL, a column decoder CD, a word decoder WD, and the above-mentioned shift register SR. The word decoder comprises a NOR gate NG for decoding address signals and an electronic switch SW for every word line WL.

In the memory device of Fig. 1, an access operation such as a readout operation or write-in operation is effected in a state in which the switch SW is positioned so as to connect the output of the NOR gate NG to the corresponding word line WL. The word line WL is selected by a decoded signal, i.e., the output signal of the NOR gate NG, and the bit line BL is selected by the column decoder CD. Thus, the memory cell MC is selected and the access thereto is performed in a known manner.

The switch SW is controlled by a refresh enable signal RFE of, for example, a high potential level so as to connect each of the output terminals of the shift register SR to the corresponding word lines. The shift register SR shifts a data "1" cyclically, and selects a word line sequentially, thereby refreshing memory cells connected to each word line.

Figure 2 illustrates a structure of a shift register as an embodiment of the present invention used, for example, in the memory device of Fig. 1. In Fig. 2, the circuit portion surrounded by a dot-dash line constitutes a circuit of one stage of the shift register, and comprises three MIS transistors $Q_4$, $Q_5$, and $Q_6$, and one capacitor $C_2$.

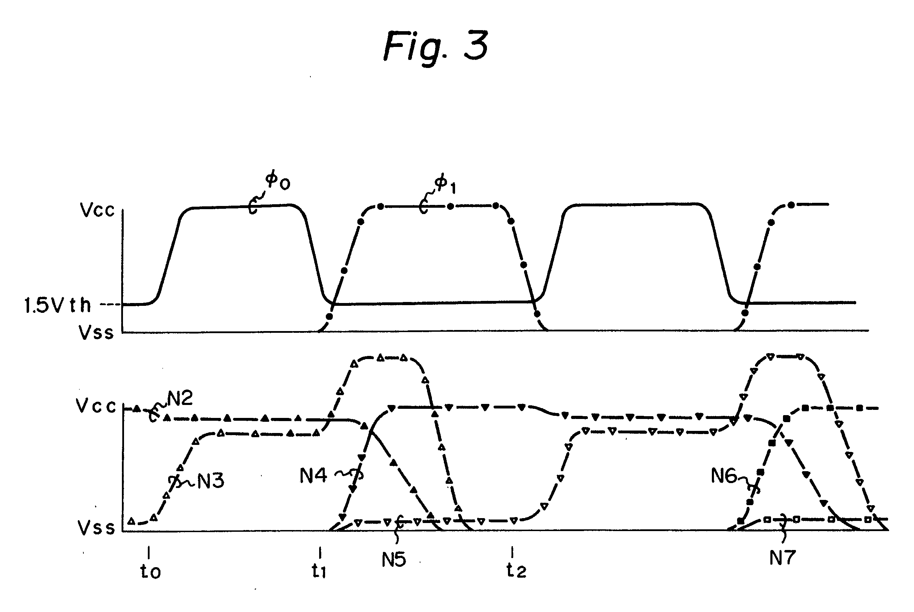

The shift register of Fig. 2 is controlled by two kinds of clock pulses $\phi_0$ and $\phi_1$, and these clock pulses $\phi_0$ and $\phi_1$ have phases mutually different, for example, by $180°$, as shown in Fig. 3. The clock pulse $\phi_1$ has an amplitude extending between power supply voltages $V_{SS}$ and $V_{CC}$. However, the voltage of a low level portion of the clock pulse $\phi_0$ is within the range of Vth to 2Vth and is preferably 1.5 Vth, although the voltage of a high level portion thereof is $V_{CC}$; where Vth is a threshold voltage of the MIS transistors, for example that of $Q_4$.

Assume that the potential of an output node N2 of the pre-stage circuit is high, as shown in Fig. 3. At a time $t_0$, the transistor $Q_4$ is turned on in response to the rising of the clock pulse $\phi_0$ from a low level, e.g. 1.5 Vth, to a high level. Hence the potential of a node N3 rises to a high level, and the transistor $Q_5$ is turned on. At a time $t_1$, the clock pulse $\phi_0$ falls and the clock pulse $\phi_1$ rises from a low level, i.e., $V_{SS}$ to a high level, i.e. $V_{CC}$, so that node N4 rises to a high level because the transistor $Q_5$ is in the on-state. At this time, ($t_1$) the potential of the node N3 rises to a higher potential level in response to the potential rise of the clock pulse $\phi_1$ due to the bootstrap effect of the transistor $Q_5$, so that the node N4 rises to $V_{CC}$ level as well as the clock signal $\phi_1$. When the potential of the node N4 rises, a transistor of the preceding stage $Q_3$ is turned on, and the potential of an output node N2 of the pre-stage circuit falls to a low level. At this time, the potential of the clock pulse $\phi_0$ is at a low level, but since the low level potential of the clock pulse $\phi_0$ is 1.5 Vth as mentioned before, when the potential of the node N2 becomes lower than 1/2 Vth, the transistor $Q_4$ is turned on, thereby pulling down the potential of the node N3 rapidly. In this way, transmission of the high level potential from the node N2 to node N4 is effected, and, similarly, the high level potential is sequentially transmitted through each circuit stage. The capacitor $C_2$ is provided so as to decrease the voltage loss caused when electric charges are transmitted from one stage to a succeeding stage, by rendering the capacitance of the output node N4 sufficiently larger than that of the input circuit, i.e. the node N5 of the succeeding stage. Since the low level voltage of the clock pulse $\phi_0$ is 1.5 Vth, when, for example, the potential of the node N4 is at a high level and the clock pulse $\phi_0$ is at a low level, i.e., 1.5 Vth, the potential of the node N5 of the next stage becomes 0.5 Vth and it is possible to keep a transistor $Q_8$ of the succeeding stage in a cut-off state. Therefore, it is possible to maintain the potential of a node N6 at a low level, i.e., $V_{SS}$. If the low level potential of the clock pulse $\phi_0$ is equal to or larger than 2 Vth, the potential of the node N6 disadvantageously rises to a value equal to or larger than $V_{SS}$ in response to the rise or fall of the clock pulse $\phi_1$. It is necessary that the low level voltage of the clock pulse $\phi_0$ is higher than Vth and lower than 2 Vth. Considering the variations in characteristics of each MIS transistor, it is preferable that the low level voltage of the clock pulse $\phi_0$ is a value near 1.5 Vth.

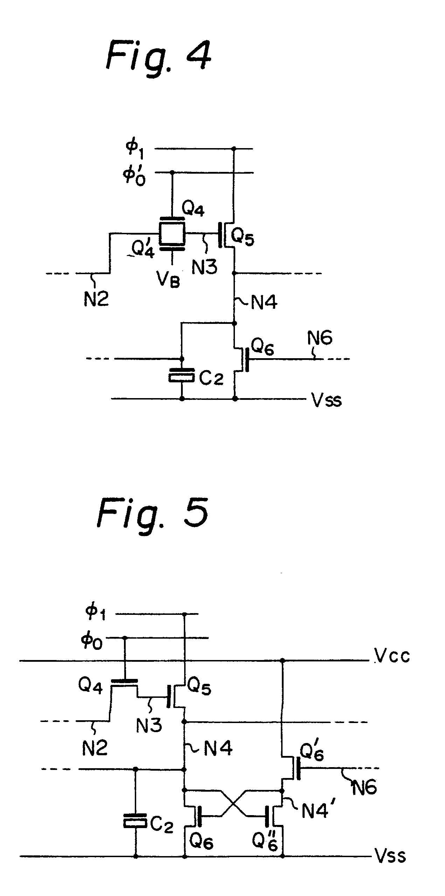

Figure 4 illustrates a circuit of one stage of a shift register as another embodiment of the present invention. The circuit of Fig. 4 differs from that of Fig. 2 in that a transistor $Q_4'$ is connected in parallel to the input transfer gate transistor $Q_4$, a voltage $V_B$ having a voltage of approximately 1.5 Vth is applied to the gate of the transistor $Q_4'$, and the clock pulse $\phi_0$ in Fig. 2 is replaced by a clock pulse $\phi_0'$. The low level voltage of the clock pulse $\phi_0'$ is $V_{SS}$ which is the same as that of the clock pulse $\phi_1$, and the clock pulse $\phi_0'$ has the same waveform as that of a pulse formed by shifting the phase of the clock pulse $\phi_1$ by $180°$, for example. The other portions of Fig. 4 are the same as those of the circuit of Fig. 2 and are designated by same reference symbols.

In the circuit of Fig. 4, the parallel circuit of the transistors $Q_4$ and $Q_4'$ effects the same operation as that of the transistor $Q_4$ of Fig. 2. That is, when the clock pulse $\phi_0'$ is low, the transistor $Q_4$ is turned off and the nodes N2 and N3 are connected only via the transistor $Q_4'$. Since the voltage $V_B$ of 1.5 Vth is applied to the gate of the transistor $Q_4'$, the transistor $Q_4'$ becomes equivalent to the transistor $Q_4$ when the clock pulse $\phi_0$ in the circuit of Fig. 2 is in a low potential level, i.e., 1.5 Vth.

In the circuit of Fig. 4, it is not necessary to strictly regulate the voltage level of the clock pulse $\phi_0'$, and it is advantageously possible to enlarge the allowable error of the voltage level of the clock pulse $\phi_0'$.

Figure 5 illustrates a circuit of one stage of a shift register as still other embodiment of the present invention. The circuit of Fig. 5 further comprises transistors $Q_6'$ and $Q_6''$ connected to the transistor $Q_6$ in the circuit of Fig. 2. The transistors $Q_6$ and $Q_6''$ are mutually cross-coupled at the gates and the drains, and a signal from the output node N6 of the succeeding stage is input to the drain of the transistor $Q_6''$, i.e., a node N4' via the transistor $Q_6'$. The other portions are the same as those of the circuit of Fig. 2 and are designated by the same reference symbols.

In the circuit of Fig. 5, a high level voltage of, for example, the node N4 is transmitted to the succeeding stage circuit, and when the output node N6 of the succeeding circuit becomes high, the potential of the node N4', i.e., the gate of the transistor $Q_6$ becomes high, thereby clamping the potential of the node N4 to $V_{SS}$. When the potential of the succeeding output node N6 becomes low after the high level voltage of the succeeding output node N6 is transmitted to a further succeeding stage, the potential of the node N4 is low and, thus, the potential of the node N4' is still high, so that the potential of the node N4 is always clamped to the voltage $V_{SS}$ by the transistor $Q_6$. Therefore, by using the circuit of Fig. 5, it is possible to prevent the node N4 from being in an electrically floating state when the node N4 is at a low level. It is also possible to increase the reliability of operation of a shift register, because the potential of the node N4 does not fluctuate due to noise and so on.

As mentioned above, according to the present invention, it is possible to constitute a shift register, for example a ring counter type shift register by using a very simple circuit structure, and to considerably reduce the width occupied by each circuit stage on a semiconductor substrate. Therefore, it becomes very advantageous to dispose the shift register parallel to a decoder as mentioned before.

## Claims

1. A shift register having a plurality of circuit stages connected in cascade and receiving first ($\phi_0$) and second ($\phi_1$) clock signals different in phase from each other for driving the shift register, each of said circuit stages comprising:

   transfer means operatively connected to receive an input signal and said first clock signal ($\phi_0$) including a first transistor ($Q_4$) having a source or drain for receiving said input signal;

   a second transistor ($Q_5$) having a gate operatively connected via said first transistor ($Q_4$) to receive said input signal, a source and a drain, one of said source and drain receiving said second clock signal ($\phi_1$), said second transistor ($Q_5$) providing an output signal (OUT) at the other of said source and drain in response to said input signal and said second clock signal ($\phi_1$); and

   a reset means ($Q_6$, $Q_6'$, $Q_6''$) for resetting said output signal (OUT); characterised in that when said first clock signal ($\phi_0$) is applied to said transfer means, said transfer means allows the transfer of said input signal and wherein said first clock signal ($\phi_0$) or said transfer means is arranged such that when said first clock signal ($\phi_0$) is not activated the gate voltage of said first transistor ($Q_4$) is held between Vth and 2Vth, where Vth is the threshold of said first transistor ($Q4$); and in that said reset means operates in response to said output signal (OUT) of a succeeding circuit stage of the shift register, the output signal of the circuit stage providing the input signal applied to the first transistor ($Q_7$) of the succeeding circuit stage of the shift register.

2. A shift register according to claim 1, wherein said reset means comprises a third transistor ($Q_6$) which is connected in series with said second transistor ($Q_5$) and which is turned on and off by the output of the succeeding circuit stage.

3. A shift register according to claim 2, wherein each of said circuit stages comprises a capacitor ($C_2$) connected in parallel with said third transistor ($Q_6$).

4. A shift register according to claim 1, wherein said reset means comprises a third transistor ($Q_6$) connected in series with said second transistor ($Q_5$), a fourth transistor ($Q_6''$) cross-coupled with said third transistor, and a fifth transistor ($Q_6'$) which is connected in series with said fourth transistor ($Q_6''$) and which is turned on and off by an output signal of the succeeding circuit stage.

5. A shift register according to claim 4, wherein each of said circuit stages comprises a capacitor ($C_2$) connected to said third transistor ($Q_6$).

6. A shift register according to any preceding claim, wherein the phases of said first clock signal ($\phi_0'$ $\phi_2$) and said second clock signal ($\phi_1$, $\phi_3$) differ from each other approximately by 180 degrees.

7. A shift register according to any preceding claim, wherein the voltage level of said first clock signal ($\emptyset_0$, $\emptyset_2$) reciprocates between a power supply voltage (Vcc) and a voltage within the range of Vth and 2Vth.

8. A shift register according to any of claims 1 to 6, wherein said transfer means further comprises a further transistor ($Q_4'$) which is connected in parallel with said first transistor ($Q_4$) and whose gate receives a bias voltage within the range of Vth to 2Vth, where Vth is the threshold voltage of said first transistor ($Q_4$).

**Revendications**

1. Registre à décalage comportant un ensemble d'étages de circuit connectés en cascade et recevant des premier ($\emptyset_0$) et deuxième ($\emptyset_1$) signaux d'horloge déphasés l'un par rapport à l'autre pour commander le registre à décalage, chacun desdits étages de circuit comprenant:
   un moyen de transfert connecté activement pour recevoir un signal d'entrée et ledit premier signal d'horloge ($\emptyset_0$), incluant un premier transistor ($Q_4$) comportant une source ou un drain pour recevoir ledit signal d'entrée;
   un deuxième transistor ($Q_5$) comportant une grille connectée activement par ledit premier transistor ($Q_4$) pour recevoir ledit signal d'entrée, une source et un drain, un desdits source et drain recevant ledit deuxième signal d'horloge ($\emptyset_1$), ledit deuxième transistor ($Q_5$) fournissant un signal de sortie (OUT) à l'autre desdits source et drain en réponse audit signal d'entrée et audit deuxième signal d'horloge ($\emptyset_1$); et un moyen de remise à l'état initial ($Q_6$, $Q_6'$, $Q_6''$) pour remettre à l'état initial ledit signal de sortie (OUT) ;
   caractérisé en ce que, lorsque ledit premier signal d'horloge ($\emptyset_0$) est appliqué audit moyen de transfert, ledit moyen de transfert permet le transfert dudit signal d'entrée et dans lequel ledit premier signal d'horloge ($\emptyset_0$) ou ledit moyen de transfert est agencé de telle sorte que, lorsque ledit premier signal d'horloge ($\emptyset_0$) n'est pas rendu actif, la tension de grille dudit premier transistor ($Q_4$) est maintenue entre des valeurs Vth et 2Vth, où Vth est la tension de seuil dudit premier transistor ($Q_4$), et en ce que ledit moyen de remise à l'état initial fonctionne en réponse audit signal de sortie (OUT) d'un étage de circuit suivant du registre à décalage, le signal de sortie de l'étage de circuit fournissant le signal d'entrée appliqué au premier transistor ($Q_7$) de l'étage de circuit suivant du registre à décalage.

2. Registre à décalage selon la revendication 1, dans lequel ledit moyen de remise à l'état initial comprend un troisième transistor ($Q_6$) qui est connecté en série avec ledit deuxième transistor ($Q_5$) et qui est rendu conducteur et bloqué par la sortie de l'étage de circuit suivant.

3. Registre à décalage selon la revendication 2, dans lequel chacun desdits étages de circuit comprend un condensateur ($C_2$) connecté en parallèle avec ledit troisième transistor ($Q_6$).

4. Registre à décalage selon la revendication 1, dans lequel ledit moyen de remise à l'état initial comprend un troisième transistor ($Q_6$) connecté en série avec ledit deuxième transistor ($Q_5$), un quatrième transistor ($Q_6''$) en couplage croisé avec ledit troisième transistor, et un cinquième transistor ($Q_6'$) qui est connecté en série avec ledit quatrième transistor ($Q_6''$) et qui est rendu conducteur et bloqué par un signal de sortie de l'étage de circuit suivant.

5. Registre à décalage selon la revendication 4, dans lequel chacun desdits étages de circuit comprend un condensateur ($C_2$) connecté audit troisième transistor ($Q_6$).

6. Registre à décalage selon l'une quelconque des revendications 1 à 5, dans lequel les phases dudit premier signal d'horloge ($\emptyset_0$,$\emptyset_2$) et dudit deuxième signal d'horloge ($\emptyset_1$,$\emptyset_3$) diffèrent entre elles approximativement de 180 degrés.

7. Registre à décalage selon l'une quelconque des revendications 1 à 6, dans lequel le niveau de tension dudit premier signal d'horloge ($\emptyset_0$,$\emptyset_2$) alterne entre une tension de source d'alimentation (Vcc) et une tension comprise dans l'intervalle entre Vth et 2Vth.

8. Registre à décalage selon l'une quelconque des revendications 1 à 6, dans lequel ledit moyen de transfert comprend en outre un autre transistor ($Q_4'$) qui est connecté en parallèle avec ledit premier transistor($Q_4$) et dont la grille reçoit une tension de polarisation comprise dans l'intervalle entre Vth et 2Vth, où Vth est la tension de seuil dudit premier transistor ($Q_4$).

**Patentansprüche**

1. Schieberegister mit einer Vielzahl von Schaltungsstufen, die in Kaskade verbunden sind und erste ($\Phi_0$) und zweite ($\Phi_1$) Taktsignale empfangen, die in ihrer Phase voneinander verschieden sind, um das Schieberegister zu treiben, wobei jede der genannten Schaltungsstufen umfaßt:

eine Transfereinrichtung, die wirkungsmäßig verbunden ist, um ein Eingangssignal und das genannte erste Taktsignal ($\Phi_0$) zu empfangen, und die einen ersten Transistor ($Q_4$) enthält, der eine Source oder ein Drain hat, um das genannte Eingangssignals zu empfangen;

einem zweiten Transistor ($Q_5$), der ein Gate hat, das wirkungsmäßig über den genannten ersten Transistor ($Q_4$) verbunden ist, um das genannte Eingangssignal zu empfangen, und einen Sourcebereich und einen Drainbereich, wobei einer, der Source- oder der Drainbereich, das genannte zweite Taktsignal ($\Phi_1$) empfängt, welcher zweite Transistor ($Q_5$) ein Ausgangssignal (OUT) an den anderen, den Drain- oder den Sourcebereich, liefert, ansprechend auf das genannte Eingangssignal und das genannte zweite Taktsignal ($\Phi_1$);

eine Rücksetzeinrichtung ($Q_6$, $Q_6'$, $Q_6''$), zum Zurücksetzen des genannten Ausgangssignals (OUT); dadurch gekennzeichnet, daß dann, wenn das genannte erste Taktsignal ($\Phi_0$) der genannten Transfereinrichtung zugeführt wird, die genannte Transfereinrichtung den Transfer des genannten Eingangssignals erlaubt und, bei der das genannte erste Taktsignal ($\Phi_0$) oder die genannte Transfereinrichtung so angeordnet ist, daß dann, wenn das genannte erste Taktsignal ($\Phi_0$) nicht aktiviert wird, die Gatespannung des genannten ersten Transistors ($Q_4$) zwischen Vth und 2Vth gehalten wird, wobei Vth die Schwellenwertspannung des genannten ersten Transistors ($Q_4$) ist; und daß die genannte Rücksetzeinrichtung ansprechend auf das genannte Ausgangssignal (OUT), von einer folgenden Schaltungsstufe des Schieberegisters betätigt wird, wobei das Ausgangssignal der Schaltungsstufe das Eingangssignal liefert, das dem ersten Transistor ($Q_7$) der nachfolgenden Schaltungsstufe des Schieberegisters zugeführt wird.

2. Schieberegister nach Anspruch 1, bei dem die genannte Rücksetzeinrichtung einen dritten Transistor ($Q6$) umfaßt, der in Reihe mit dem genannten zweiten Transistor ($Q_5$) verbunden ist und der durch den Ausgang der nachfolgenden Schaltungsstufe ein- und ausgeschaltet wird.

3. Schieberegister bei dem jede der genannten Schaltungsstufen einen Kondensator ($C_2$) um-

faßt, der parallel mit dem genannten dritten Transistor ($Q_6$) verbunden ist.

4. Schieberegister nach Anspruch 1 bei dem die genannte Rücksetzeinrichtung einen dritten Transistor ($Q6$) umfaßt, der in Reihe mit dem genannten zweiten Transistor ($Q_5$) verbunden ist, einen vierten Transistor ($Q_6''$), der mit dem genannten dritten Transistor kreuzartig gekoppelt ist, und einen fünften Transistor ($Q_6'$), der in Reihe mit dem genannten vierten Transistor ($Q_6''$) verbunden ist und der durch das Ausgangssignal der nachfolgenden Schaltungsstufe ein- und ausgeschaltet wird.

5. Schieberegister nach Anspruch 4, bei dem jede der genannten Schaltungsstufen einen Kondensator ($C_2$) umfaßt, der mit dem genannten dritten Transistor ($Q_6$) verbunden ist.

6. Schieberegister nach einem der vorhergehenden Ansprüche, bei dem die Phasen des genannten ersten Taktsignals ($\Phi_0$, $\Phi_2$) und des genannten zweiten Taktsignals ($\Phi_1$, $\Phi_3$) voneinander etwa um $180^\circ$ differieren.

7. Schieberegister nach einem der vorhergehenden Ansprüche, bei dem der Spannungspegel des genannten ersten Taktsignals ($\Phi_0$, $\Phi_2$) sich zwischen einer Energieversorgungsspannung (Vcc) und einer Spannung innerhalb des Bereichs von Vth und 2vth hin und her bewegt.

8. Schieberegister nach einem der Ansprüche 1 bis 6, bei dem die genannten Transgereinrichtung ferner einen weiteren Transistors ($Q_4'$) umfaßt, der parallel mit dem genannten ersten Transistor ($Q_4$) verbunden ist und dessen Gate eine Vorspannung innerhalb des Bereiches von Vth bis 2Vth empfängt, wobei Vth die Schwellenwertspannung des genannten ersten Transistors ($Q_4$) ist.

## Fig. 1

## Fig. 2

*Fig. 3*

EP 0 138 406 B1

# Fig. 4

# Fig. 5